# EUROPEAN PATENT SPECIFICATION

(11) **EP 1 920 446 B1**
(45) Date of publication and mention of the grant of the patent: **10.12.2014**
(21) Application number: 06779622.7
(22) Date of filing: 01.09.2006
(51) Int. Cl.: H01F 5/02

(54) **COIL FORMER**
SPULENBILDNER
GABARIT DE BOBINE

(30) Priority: 02.09.2005 GB 0517859
(43) Date of publication of application: 14.05.2008
(73) Proprietor: Nanobeam Limited, Cambridge, Cambridgeshire CB1 3HD (GB)
(72) Inventor: ZHANG, Tao, Cambridge CB1 8YU (GB)
(74) Representative: Piotrowicz, Pawel Jan Andrzej
(86) International application number: PCT/GB2006/050268
(87) International publication number: WO 2007/026181

(56) References cited:
- US-A- 2 982 889
- US-A- 4 093 132
- US-A- 4 707 313

## Description

### Field of the invention

The present invention relates to a coil former.

### Background art

US-A-2982889 describes hermetically sealing electrical devices such a transformers, armature-receiving coils, resistor and solenoids. It describes a disc of glass provided with grooves in spiral form.

In charged particle beam systems, such as electron-beam lithography systems, coils are used for deflecting and focussing beams of charged particles. The coils are carried on coil formers comprising an electrically insulating material, such as a ceramic or plastics material.

GB-A-2389225 describes a coil former made from a high-strength, non-magnetic and electrically non-conductive ceramic material having a high thermal conductivity and a low coefficient of thermal expansion. However, few ceramics with suitable magnetic, electrical and thermal properties can be used because they cannot be reliably machined into complex shapes without breaking. Suitable ceramics which can be so machined, such as SHAPAL-M (registered trade mark), tend to be expensive. In any case, even if a ceramic can be machined, it is still difficult to machine the ceramic into a complex shape.

The present invention seeks to ameliorate at least some these drawbacks.

### Summary of the invention

According to the present invention there is provided a laminated ceramic coil former as claimed in claim 1.

This can help to simplify manufacture of a coil former since individual ceramic plates can be cut from a sheet of ceramic material. This allows a wider range of ceramic materials to be used.

According to the present invention there is further provided a deflector unit for a charged particle beam system comprising a coil former according to the first aspect of the invention.

According to the present invention there is yet further provided a method of fabricating a coil former according to claim 15.

Optional features are designated in the dependent claims.

### Brief description of the drawings

An embodiment of the present invention will now be described, by way of example with reference to the accompanying drawings in which:
Figure 1 is a perspective view of a coil former in accordance with the present invention;
Figure 2 is a perspective view of a ceramic plate in accordance with the present invention;
Figure 3 is a plan view of the ceramic plate shown in Figure 2;
Figure 4 is an elevation view of the ceramic plate shown in Figure 2;
Figure 5 is a perspective view of the coil former shown in Figure 1 carrying a coil; and
Figure 6 is a perspective view of a coil shown in Figure 5.

### Detailed description of embodiment

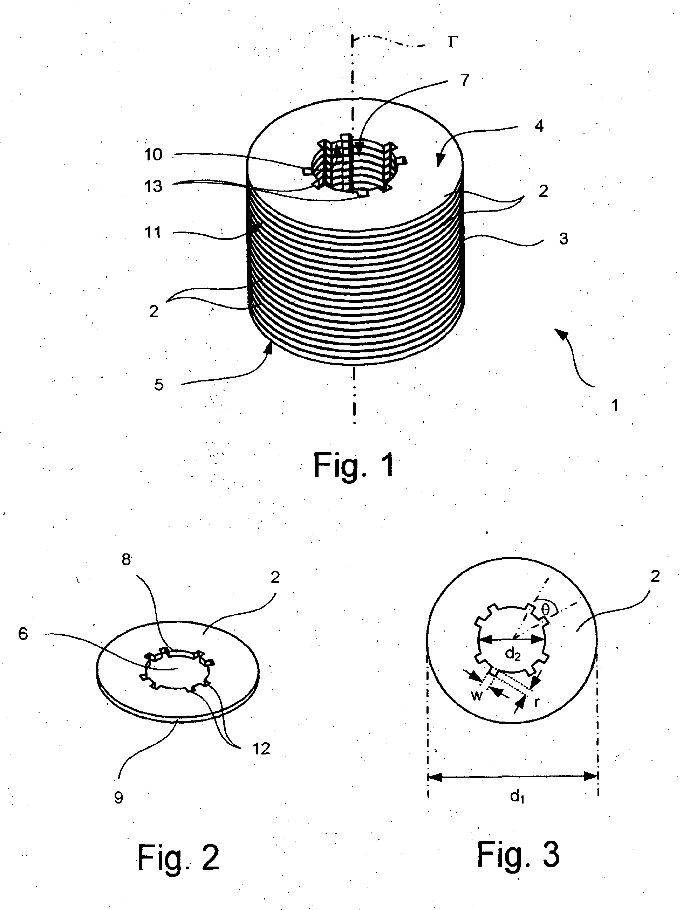

Referring to Figures 1 to 4, an embodiment of a coil former 1 according to the present invention comprises a plurality of ceramic plates 2 arranged to form a laminate 3 between first and second ends 4, 5. The ceramic plates 2 generally take the form of flat, annular discs. Each ceramic plate 2 has an opening 6 therein such that when the plates 2 are arranged to form the laminate 3, a passage 7 is defined between the first and second ends 4, 5. The laminate 3 preferably comprises between 10 and 30 ceramic plates 2. The laminate 3 is generally tubular. The laminate 3 may be elongate along an axis F along which plates 2 are arranged.

The ceramic plates 2 are formed from aluminium nitride. However, other non-magnetic and electrically non-conductive ceramic materials may be used, such as boron nitride, silicon carbide and aluminium oxide. As will be explained in more detail later, the ceramic plates 2 can be cut from a sheet of ceramic material, for example by laser cutting. Thus, the ceramic material need not be machinable and so softer ceramic materials can be used.

The ceramic plates 2 are held together using heat-resistant glue, such as cyanbacrylate. Additionally or alternatively, the ceramic plates 2 may be held together using a clamp (not shown).

Each ceramic plate 2 has an inner and outer edge or circumference 8, 9. When the plates 2 are arranged in the support 3, the inner and outer edges 8, 9 define inner and outer walls 10, 11 respectively. The inner wall 10 defines the passage 7. The passage 21 generally has a uniform thickness along its length.

The inner edge 8 of each plate 2 is furnished with at least one pair of radial slots 12. Thus, when the plates 2 are arranged and are rotationally aligned, a set of elongate slots 13 are formed running along the inner wall 10 of the passage 7 between the first and second ends 4, 5 of the laminate 3. Rotational alignment can be achieved by co-extensively superimposing or stacking identical ceramic plates 2.

The ceramic plates 2 are preferably in the form of flat, annular discs having co-axial inner and outer circumferences 8, 9.

The ceramic plates 2 preferably have a diameter, d₁, between 10 and 50 mm and the opening 6 has a diameter, d₂, between 5 and 25 mm. The slots 12 preferably have a radial depth, r, of between 0.5 to 2 mm, a width of between 0.5 to 2 mm and arranged at alternating 30 and 60-degree intervals, θ. The ceramic plates 2 preferably have a thickness, t, between 0.5 and 2 mm. In this example, the ceramic plates 2 each have a thickness of 1 mm.

A method of manufacturing the ceramic plates 2 will now be described:
The plates 2, including the openings 6, are laser cut from a sheet of commercially-available ceramic material (not shown), for example using a Nd:YAG laser, in a manner well known *per se.*

Low viscosity, heat-resistant glue is applied to an upper surface of a plate 2 and another plate 2 is co-extensively placed on top. Low viscosity glue has an advantage that a uniform thickness of glue can be applied. The plates 2 are stacked ensuring that the slots 12 are arranged in a line parallel with axis F (Figure 1).

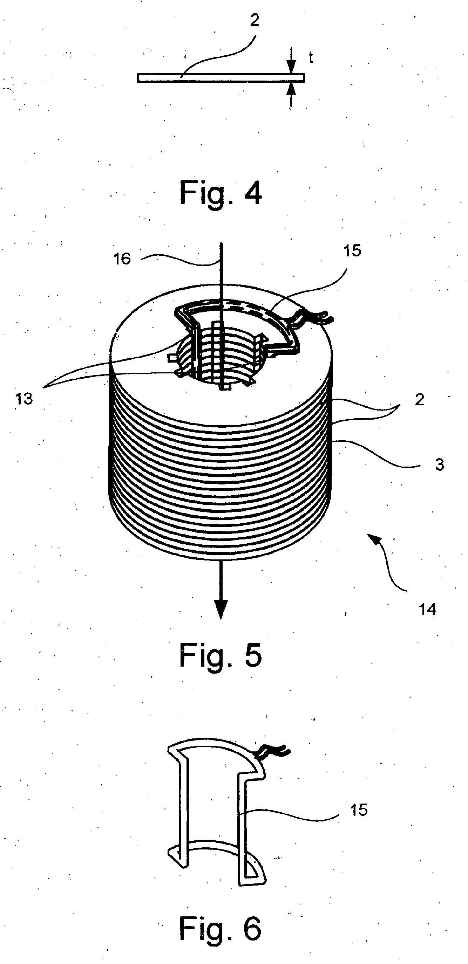

Referring to Figures 5 and 6, a deflector unit 14 for use in a charged particle beam system (not shown) comprises the coil former 1 (Figure 1) and at least one coil 15 supported by the coil former 1. For clarity, only one coil 15 is shown. The coil 15 comprises one or more turns of copper wire having an insulating coating. At least part of the coil 15 is carried in a pair of elongate slots 13.

In use, when a current passes through the coil 15, a magnetic field (not shown) is generated which influences a charged particle beam 16 passing through the deflector unit 14.

The deflector unit 14 may be used in an electron beam lithography system, ion-beam implantation system or electron microscope. Further details regarding arrangement and operation of a deflector unit in a charged particle beam system can be found in GB-A-2389225 *supra.*

It will be appreciated that many modifications may be made to the embodiment hereinbefore described. For example, the ceramic plates need not all be identical. The ceramic plates need not be circular, but can be polygonal. Furthermore, the opening need not be generally circular, but can be polygonal. The plates need not form a closed structure around the aperture.

## Claims

1. A non-magnetic, laminated ceramic coil former (1) having a central axis (Γ) for a deflector unit (14) for deflecting a charged particle beam (16) passing through the deflector unit, along the central axis, for use in a charged particle beam system.

2. A coil former according to claim 1, comprising a plurality of ceramic plates (2) arranged to form a laminate (3) between first and second ends (4, 5), each plate having an opening therein such that when the plates are arranged in the laminate, a passage (7) is defined between the first and second ends.

3. A coil former according to claim 2, wherein the ceramic plates (2) are arranged co-extensively.

4. A coil former according to claim 2 or 3, wherein the ceramic plates (2) comprise flat, annular discs.

5. A coil former according to any one of claims 2 to 4, wherein each ceramic plate (2) includes at least one pair of slots (12) extending from the opening, such that, when said plates are arranged in the laminate and are rotationally aligned, the laminate defines at least one pair of elongate slots (13) for receiving a coil.

6. A coil former according to any one of claims 2 to 5, wherein the ceramic plates (2) are identical.

7. A coil former according to any one of claims 2 to 6, wherein the ceramic plates (2) are held together using heat-resistant glue.

8. A coil former according to any one of claims 2 to 7, wherein the ceramic plates (2) are held together using a clamp between the first and second ends (4, 5).

9. A coil former according to any one of claims 2 to 8, wherein the ceramic plates (2) comprise aluminium nitride.

10. A coil former according to one of claims 2 to 9, wherein the ceramic plates (2) have a thickness between 0.5 mm and 2 mm.

11. A coil former according to one of claims 2 to 10, wherein the ceramic plates (2) have a diameter between 10 mm and 50 mm.

12. A coil former according to one of claims 2 to 11, comprising between 10 and 30 plates.

13. A deflector unit (14) for a charged particle beam system comprising:
a coil former (1) according to any preceding claim; and
at least one coil (15) wound onto said former.

14. A deflector unit according to claim 13, comprising a pair of coils (15) arranged diametrically opposite to one another on either side of a passage (7).

15. A method of fabricating a coil former (1) for use in a charged particle beam system comprising:
cutting a plurality of ceramic plates (2) from a sheet of ceramic material, each ceramic plate having an opening; and
arranging the ceramic plates such that the plurality of ceramic plates form a non-magnetic laminate between first and second ends (4, 5), and a passage (7) is defined between the first and second ends having a central axis (Γ) for a deflector unit (14) for deflecting a charged particle beam (16) passing through the deflector unit, along the central axis.

## Patentansprüche

1. Nichtmagnetischer, laminierter keramischer Spulenformer (1) mit einer mittleren Achse (Γ) für eine Umlenkeinheit (14) zum Umlenken eines durch die Umlenkeinheit passierenden geladenen Partikelstrahls (16) entlang der mittleren Achse, zur Verwendung in einem geladenen Partikelstrahlsystem.

2. Spulenformer nach Anspruch 1, der mehrere keramische Platten (2) umfasst, die zu einem Laminat (3) zwischen einem ersten und einem zweiten Ende (4, 5) angeordnet sind, wobei jede Platte eine Öffnung darin aufweist, so dass, wenn die Platten in dem Laminat angeordnet sind, ein Kanal (7) zwischen dem ersten und zweiten Ende definiert wird.

3. Spulenformer nach Anspruch 2, wobei die keramischen Platten (2) co-extensiv angeordnet sind.

4. Spulenformer nach Anspruch 2 oder 3, wobei die keramischen Platten (2) flache, ringförmige Scheiben umfassen.

5. Spulenformer nach einem der Ansprüche 2 bis 4, wobei jede keramische Platte (2) wenigstens ein Paar Schlitze (12) aufweist, die sich so von der Öffnung erstrecken, dass das Laminat, wenn die genannten Platten in dem Laminat angeordnet und rotational ausgerichtet sind, wenigstens ein Paar längliche Schlitze (13) zum Aufnehmen einer Spule definiert.

6. Spulenformer nach einem der Ansprüche 2 bis 5, wobei die keramischen Platten (2) identisch sind.

7. Spulenformer nach einem der Ansprüche 2 bis 6, wobei die keramischen Platten (2) mit hitzebeständigem Klebstoff zusammengehalten werden.

8. Spulenformer nach einem der Ansprüche 2 bis 7, wobei die keramischen Platten (2) mit einer Klammer zwischen dem ersten und dem zweiten Ende (4, 5) zusammengehalten werden.

9. Spulenformer nach einem der Ansprüche 2 bis 8, wobei die keramischen Platten (2) Aluminiumnitrid umfassen.

10. Spulenformer nach einem der Ansprüche 2 bis 9, wobei die keramischen Platten (2) eine Dicke zwischen 0,5 und 2 mm haben.

11. Spulenformer nach einem der Ansprüche 2 bis 10, wobei die keramischen Platten (2) einen Durchmesser zwischen 10 mm und 50 mm haben.

12. Spulenformer nach einem der Ansprüche 2 bis 11, der zwischen 10 und 30 Platten umfasst.

13. Umlenkeinheit (14) für ein geladenes Partikelstrahlsystem, die Folgendes umfasst:
einen Spulenformer (1) nach einem vorherigen Anspruch; und
wenigstens eine auf den genannten Former gewickelte Spule (15).

14. Umlenkeinheit nach Anspruch 13, die ein Paar Spulen (15) umfasst, die einander diametral gegenüberliegend auf beiden Seiten eines Kanals (7) angeordnet sind.

15. Verfahren zur Herstellung eines Spulenformers (1) zur Verwendung in einem geladenen Partikelstrahlsystem, das Folgendes beinhaltet:
Schneiden mehrerer keramischer Platten (2) von einem Blech aus keramischem Material, wobei jede keramische Platte eine Öffnung aufweist; und
Anordnen der keramischen Platten so, dass die mehreren keramischen Platten ein nichtmagnetisches Laminat zwischen dem ersten und zweiten Ende (4, 5) bilden, und ein Kanal (7) zwischen dem ersten und dem zweiten Ende mit einer mittleren Achse (Γ) für eine Umlenkeinheit (14) zum Umlenken eines durch die Umlenkeinheit passierenden geladenen Partikelstrahls (16) entlang der mittleren Achse definiert wird.

## Revendications

1. Gabarit de bobine à céramique stratifiée non magnétique (1) possédant un axe central (Γ) pour une unité déflectrice (14) destinée à assurer la déflexion d'un faisceau à particules chargées (16) passant à travers l'unité déflectrice, le long de l'axe central, en vue d'une utilisation dans un système de faisceaux à particules chargées.

2. Gabarit de bobine selon la revendication 1, comportant une pluralité de plaques en céramique (2) agencées de façon à constituer un stratifié (3) entre des première et seconde extrémités (4, 5), chaque plaque possédant une ouverture dans celle-ci de telle sorte que, lorsque les plaques sont agencées dans le stratifié, un passage (7) est défini entre les première et seconde extrémités.

3. Gabarit de bobine selon la revendication 2, les plaques en céramique (2) étant agencées en co-extension.

4. Gabarit de bobine selon la revendication 2 ou 3, les plaques en céramique (2) comportant des disques annulaires plats.

5. Gabarit de bobine selon l'une quelconque des revendications 2 à 4, chaque plaque en céramique (2) incluant au moins une paire de fentes (12) lesquelles se prolongent à partir de l'ouverture de telle sorte que, lorsque lesdites plaques sont agencées dans le stratifié et sont alignées par rotation, le stratifié va définir au moins une paire de fentes allongées (13) destinées à recevoir une bobine.

6. Gabarit de bobine selon l'une quelconque des revendications 2 à 5, les plaques en céramique (2) étant identiques.

7. Gabarit de bobine selon l'une quelconque des revendications 2 à 6, les plaques en céramique (2) étant maintenues ensemble grâce à l'utilisation d'une colle résistant à la chaleur.

8. Gabarit de bobine selon l'une quelconque des revendications 2 à 7, les plaques en céramique (2) étant maintenues ensemble grâce à l'utilisation d'une pince entre les première et seconde extrémités (4, 5).

9. Gabarit de bobine selon l'une quelconque des revendications 2 à 8, les plaques en céramique (2) comprenant du nitrure d'aluminium.

10. Gabarit de bobine selon l'une quelconque des revendications 2 à 9, les plaques en céramique (2) ayant une épaisseur entre 0,5 mm et 2 mm.

11. Gabarit de bobine selon l'une quelconque des revendications 2 à 10, les plaques en céramique (2) ayant un diamètre entre 10 mm et 50 mm.

12. Gabarit de bobine selon l'une quelconque des revendications 2 à 11, comportant entre 10 et 30 plaques.

13. Unité déflectrice (14) pour un système de faisceaux à particules chargées, comprenant :
un gabarit de bobine (1) selon l'une quelconque des revendications précédentes ; et
au moins une bobine (15) enroulée sur ledit gabarit.

14. Unité déflectrice selon la revendication 13, comprenant une paire de bobines (15) agencées de façon diamétralement opposées l'une à l'autre sur chaque côté d'un passage (7).

15. Procédé de fabrication d'un gabarit de bobine (1) destiné à être utilisé dans un système de faisceaux à particules chargées, comprenant les opérations consistant à :
découper une pluralité de plaques en céramique (2) à partir d'une feuille de matière céramique, chaque plaque en céramique présentant une ouverture ; et
agencer les plaques en céramique de telle sorte que la pluralité de plaques en céramique forme un stratifié non magnétique entre des première et seconde extrémités (4, 5), et qu'un passage (7) soit défini entre les première et seconde extrémités possédant un axe central (Γ) pour une unité déflectrice (14) afin d'assurer la déflexion d'un faisceau à particules chargées (16) passant à travers l'unité déflectrice, le long de l'axe central.
